# EUROPEAN PATENT SPECIFICATION

(11) **EP 0 418 592 B1**
(45) Date of publication and mention of the grant of the patent: **06.11.1996**
(21) Application number: 90116276.8
(22) Date of filing: 24.08.1990
(51) Int. Cl.: C23C 16/44, C23G 5/00, B08B 7/00, H01L 21/285

(54) **Cleaning process for removal of deposits from the susceptor of a chemical vapor deposition apparatus**
Reinigungsverfahren zur Entfernung von Ablagerungen auf dem Träger in einer CVD-Anlage
Procédé de nettoyage pour enlever des dépôts du suscepteur dans un dispositif de dépôt chimique en phase vapeur

(30) Priority: 25.08.1989 US 398689
(43) Date of publication of application: 27.03.1991
(73) Proprietor: APPLIED MATERIALS INC., Santa Clara California 95052 (US)
(72) Inventor: Chang, Mei, Cupertino California 95014 (US)
(74) Representative: Diehl, Hermann O. Th., Dr.

(56) References cited:
- EP-A- 0 296 891
- PATENT ABSTRACTS OF JAPAN, vol. 12, no. 180 (P-709), 27th May 1988; & JP-A-62 291 664 (SHARP) 18-12-1987
- English Translation of JP-A-62-291664

## Description

This invention relates to the processing of semiconductor wafers in a vacuum deposition apparatus.

In the processing of a semiconductor wafer to form integrated circuit structures therein, it is desirable to deposit materials such as, for example, tungsten on the wafer by a chemical vapor deposition (CVD) process, either by a blanket deposition followed by a patterning step, or by selective deposition of tungsten over a mask layer, such as an oxide layer, already patterned to expose silicon or aluminum surfaces on which the tungsten will selectively deposit.

In either case, deposits of materials such as tungsten usually accumulate on the susceptor (base or support on which the semiconductor wafer rests during the deposition) in the CVD deposition chamber and such deposits must be removed periodically since they tend to change the dimensions of the chamber as well as to flake off the susceptor surfaces and onto the wafer being processed in the chamber, or change the deposition environment chemically, especially for subsequent selective deposition processes.

In the prior art, it has been conventional to remove such deposits using a plasma-assisted fluorine etch. A gaseous source of fluorine is fed into the vacuum deposition chamber and a plasma is then ignited in the chamber during the gas flow, by connecting to an rf source the faceplate through which gases are fed into the vacuum deposition chamber during the deposition. The base or susceptor on which the wafer normally rests during the CVD deposition will be grounded. The resulting fluorine chemistry reacts with the deposits, such as tungsten or tungsten silicide deposits, and the resulting reaction product is removed from the chamber by the vacuum evacuation system.

While this process satisfactorily removes tungsten or other deposits from the susceptor in the vacuum chamber, the cleaning process, in turn, leaves fluorine residues in the vacuum chamber which can interfere, for example, with subsequent tungsten depositions therein. If such a subsequent tungsten deposition in the chamber is a blanket deposition, the resulting tungsten layer will be non-uniform in thickness, probably due to inhibition of the tungsten deposition by the fluorine residues. If the next deposition is a selective tungsten deposition, the presence of fluorine residues in the chamber inhibits the deposition of tungsten on the exposed silicon or aluminum surfaces.

The document JP-A-62 291 664 discloses using a gas mixture of carbon halide gases, such as chlorinated carbon gas or fluorinated carbon gas, and oxygen to avoid roughening the surface of an aluminum workpiece when cleaning it from foreign matters in the presence of a plasma; and then exposing the aluminum workpiece to H₂ gas in the presence of a plasma.

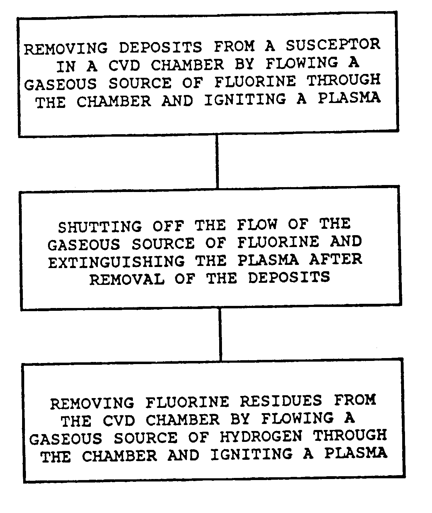

It would, therefore, be desirable to provide an improved process for the removal of deposits, such as tungsten and tungsten silicide deposits, from the susceptor in a vacuum chamber after a deposition such as a CVD tungsten depositions wherein no fluorine residues would remain in the deposition chamber at the conclusion of the cleaning process. This object is solved by the process of independent claim 1. Further advantageous features of the process are evident from the description and the single figure.

The invention provides an improved cleaning process for the removal of deposits, such as tungsten or tungsten silicide deposits, from a vacuum deposition apparatus without leaving fluorine residues.
According to one aspect of this invention an improved process is provided for the removal of deposits, such as tungsten or tungsten silicide deposits, from the susceptor in a vacuum deposition chamber wherein fluorine residues, remaining from a first cleaning step to remove such deposits on the susceptor surfaces, are removed in a second cleaning step.

It is another aspect of this invention to provide an improved process for the removal of deposits, such as tungsten or tungsten silicide deposits, from the surfaces of a susceptor in a vacuum deposition chamber wherein fluorine residues, remaining from a first cleaning step to remove such deposits, are removed in a second cleaning step by contacting the fluorine residues with a gaseous source of hydrogen in a plasma-assisted etch.

It is still another aspect of this invention to provide an improved process for the removal of deposits, such as tungsten or tungsten silicide deposits, from a vacuum deposition chamber which comprises using a plasma-assisted fluorine etch in a first step to remove such deposits and a plasma-assisted hydrogen etch in a second cleaning step to remove fluorine residues remaining from the first cleaning step.

These and other details of the invention will be apparent from the following description and accompanying flowsheet, shown in the drawing.

In accordance with the invention, deposits such as tungsten or tungsten silicide deposits, remaining from a CVD process for depositing same on a semiconductor wafer are removed from the susceptor in a vacuum deposition chamber without leaving fluorine residues by first flowing a gaseous source of fluorine into a vacuum deposition chamber and igniting a plasma in the chamber while the gaseous source of fluorine is flowing therein to remove the deposits; and then flowing a gaseous source of hydrogen into the chamber while maintaining a plasma in the chamber during the flow of the gaseous hydrogen source through the chamber to remove any fluorine residues remaining in the chamber.

The buildup of deposits, such as tungsten or tungsten silicide, on the surfaces of the susceptor in a vacuum chamber used for the chemical vapor deposition (CVD) of such materials on a semiconductor wafer is first removed by flowing a gaseous source of fluorine through the vacuum chamber at a flow rate within a range of from 20 to 200 standard cubic centimeters per minute (sccm) while maintaining the pressure in the vacuum chamber within a range of from about 0.2 to about 1 Torr* and the temperature within a range of from 450°C to 475°C when the chamber and the susceptor are used for blanket depositions, and within the range of from 250°C to 400°C when the chamber and the susceptor therein are used for selective depositions.
*1 Torr = 1.333mbar
1 mm Hg = 1 Torr

The gaseous source of fluorine consists of any one or more fluorine-containing gases capable of forming fluorine radicals to cause reaction between such fluorine radicals and the deposits. Examples of such fluorine-containing gases are SF₆, CF₄, C₂F₆, and NF₃. The gaseous source of fluorine may further include inert or non-reactive gases such as argon, neon, or helium at a flow rate of up to 200 sccm. When such inert gases are mixed with the gaseous source of fluorine, the total flow of gas into the chamber is the sum of the mixture, i.e., the amount of the fluorine-containing gas entering the chamber should not be diminished by the presence of the inert gas in the gas mixture.

While the gaseous source of fluorine is flowing through the vacuum chamber, a plasma is ignited in the chamber by energizing an rf source connected between two electrodes in the chambers which may be spaced within a range of from about 0.51 to about 2.54 cm (about 200 to 1000 mils) apart. These two electrodes will normally respectively comprise the grounded base or susceptor, and the faceplate or "showerhead" through which the gaseous source of fluorine is distributed into the vacuum chamber, and which is directly connected to the rf power source.

The power used by the rf source to maintain the plasma in the vacuum chamber will normally be within a range of from about 50 to about 400 watts, with the actual amount of power used depending upon the size of the susceptor in the chamber, which will, in turn, depend upon the size of the wafers which have been previously processed in the chamber.

The time period during which the plasma-assisted fluorine etch is carried out will depend upon the thickness of the tungsten deposits or residues in the chamber as well as the power level and the flow rate of the gaseous fluorine source. The higher the flow rate and/or the higher the power level, within the ranges discussed above, the faster the tungsten deposits will be removed. Usually the time will be within a range of from about 30 seconds to about 2 minutes per µm of thickness of deposited material on the susceptor surfaces.

After the deposits have been removed from the susceptor in the vacuum chamber, in accordance with the improved process of the invention, the resulting fluorine residues must be removed to avoid interference by such fluorine residues with subsequent depositions to be carried out in the cleaned vacuum deposition chamber.

The fluorine residues are removed by flowing a gaseous source of hydrogen through the vacuum chamber while maintaining a plasma flow in the chamber. The gaseous source of hydrogen is flowed through the chamber at a flow rate within a range of from about 100 to about 500 sccm while maintaining the other reaction conditions the same as during the fluorine etch, i.e., a pressure within a range of from about 0.2 to about 1 Torr, and a temperature within a range of from about 150°C to about 525°C, preferably either within a range of from about 450°C to about 475°C, or within a range of from about 250°C to about 400°C, depending upon the intended use of the susceptor and the deposition chamber as previously discussed with respect to the fluorine etch.

As in the first cleaning step, the gaseous source of hydrogen may further optionally include inert or non-reactive gases such as argon, neon, or helium in amounts of up to about 200 sccm which flow rate is additive to the flow rate of the gaseous source of hydrogen in computing the total flow rate of gases into the vacuum chamber during this second cleaning step.

Examples of hydrogen-containing gases which are used in this step of the process are hydrogen (H₂), boron hydride (B₂H₆), phosphorus hydride (PH₃), and organic sources such as 1-2 carbon hydrocarbons, e.g., CH₄, and C₂H₆, although the use of H₂ is preferred. When the subsequent deposition in the chamber is to be a blanket tungsten deposit, silane (SiH₄) may also be used as the source of hydrogen. However, silane should not be used if the subsequent tungsten depositions are to be selective depositions, since silane will leave some silicon residues which will not interfere with a blanket tungsten deposition, but may interfere with a selective tungsten deposition, for example, over a silicon oxide mask.

The reaction between the fluorine residues and the hydrogen-containing gas is also assisted by a plasma which is maintained in the chamber during the flow of the gaseous hydrogen source through the chamber. As in the fluorine etch, the power level of the plasma, during the flow of the hydrogen-containing gas through the chamber, is maintained within a range of from about 50 to about 400 watts and the spacing between the electrodes in the chamber is maintained within a range of from about 200 to about 1000 mils.*
* 1 mil = .0254 mm

The plasma assisted hydrogen etch is carried out for a time period ranging from about 20 seconds to about 5 minutes to remove the fluorine residues from the chamber. Longer time periods are possible but are usually not necessary and are not, therefore, economically feasible. The actual amount of time needed to remove all of the fluorine residues will also be dependent on the plasma power and the flow rate of the gaseous source of hydrogen through the chamber.

Whether or not the time period for the plasma assisted hydrogen etch has been long enough to remove all of the fluorine residues can be empirically ascertained, if necessary, by examining the uniformity of a subsequent blanket deposition, for example, of a tungsten layer on a semiconductor wafer. If the thickness of the tungsten layer does not vary by more than about 1% across the wafer, all of the fluorine residues have been removed. On the other hand, if some of the fluorine residues remain in the chamber, the thickness of the tungsten layer may vary by as much as 3-4% across the surface of the wafer.

In a preferred embodiment, the flow of the gaseous source of fluorine is stopped, i.e., the gas is shut off, and the plasma extinguished after the first cleaning step. This avoids undesired reaction between the gaseous source of fluorine and the gaseous source of hydrogen as might otherwise occur if the two cleaning steps were merged by gradually turning off the flow of the gaseous source of fluorine while gradually turning on the flow of the gaseous source of hydrogen. After the flow of the gaseous source of hydrogen into the vacuum chamber commences, the plasma is reignited and then remains on during the second cleaning step.

The following example will serve to further illustrate the improved cleaning process of the invention.

### Example

A vacuum deposition chamber which had been used for the deposition of tungsten on semiconductor wafers, and which had accumulated CVD tungsten deposits of an average thickness of about 1 µm on the surfaces of the susceptor, was cleaned by first flowing NF₃ through the vacuum chamber at a flow rate of 100 sccm while maintaining a pressure in the chamber of 0.75 Torr and a temperature of 450°C. A plasma was ignited in the chamber during the NF₃ flow at a power level of 200 watts and the spacing between the grounded susceptor or base and the faceplate, which served as the electrode connected to the rf power source, was 500 mils. The plasma-assisted fluorine etch was carried out for 2 minutes, after which the flow of NF₃ was shut off and the plasma extinguished.

Following the fluorine etch, hydrogen (H₂) was flowed through the chamter at 200 sccm while still maintaining the vacuum chamber at 0.75 Torr and at a temperature of 450°C. During the hydrogen flow through the chamber, a plasma was again ignited between the base and the faceplate at a power level of 200 watts. The plasma-assisted hydrogen etch was carried out for 30 seconds.

To test the effectiveness of the cleaning process, a semiconductor wafer was then loaded onto the cleaned susceptor and a blanket deposit of a tungsten layer was CVD applied to the wafer. The wafer was then removed from the chamber and the tungsten layer was examined for uniformity and found to have less than 1% variation in thickness.

Thus, the invention provides an improved process for the removal of accumulated deposits of materials such as tungsten or tungsten silicide from the surfaces of a susceptor in a CVD deposition chamber without leaving undesired fluorine residues by first removing the deposits with a plasma-assisted fluorine etch and then removing the fluorine residues with a plasma-assisted hydrogen etch.

## Claims

1. A process for removing deposits of tungsten or tungsten silicide from a susceptor in a vacuum deposition chamber where said chamber is maintained within a pressure range of from about 0.26 to about 1.333 mbar (about 0.2 to about 1 Torr) without leaving fluorine residues therein, comprising the steps of:
heating said susceptor and maintaining it within a temperature range of from 450° to 475°C when the chamber and the susceptor are used for blanket deposition, and from 250°C to 400°C when the chamber and the susceptor are used for selective deposition;
flowing a gaseous source of fluorine selected from the class consisting of SF₆, CF₄, C₂F₆ and NF₃ into said chamber at a rate within a range of from 20 to 200 sccm;
optionally flowing an inert or non-reactive gas into said chamber; and
igniting a plasma in said chamber at a power level within a range of 50 to 400 watts while said gaseous source of fluorine is flowing therein to remove said deposits from said susceptor;
stopping said flow of said gaseous source of fluorine into said chamber;
thereafter flowing a gaseous source of hydrogen selected from the class consisting of H₂, B₂H₆, PH₃ and a 1-2 carbon hydrocarbon into said chamber at a rate within a range of from 100 to 500 sccm;
optionally flowing an inert or non-reactive gas into said chamber; and
maintaining a plasma in said chamber at a power level within a range of from 50 to 400 watts during said flow of said gaseous source of hydrogen therein to remove residual fluorine from said susceptor, wherein said susceptor is maintained within a temperature range of from about 150°C to about 525°C during said cleaning process.

## Patentansprüche

1. Verfahren zur Entfernung von Ablagerungen von Wolfram oder Wolframsilicid von einem Aufnehmer in einer Vakuumbeschichtungskammer, wobei die Kammer innerhalb eines Druckbereichs von etwa 0,26 bis etwa 1,333 mbar (etwa 0,2 bis etwa 1 Torr) gehalten wird, ohne darin Fluorrückstände zu hinterlassen, mit folgenden Schritten:
Erwärmen des Aufnehmers und Halten des Aufnehmers innerhalb eines Temperaturbereichs von 450° bis 475°C bei Verwendung der Kammer und des Aufnehmers zur Deckbeschichtung und von 250°C bis 400°C bei Verwendung der Kammer und des Aufnehmers zur selektiven Beschichtung;
Strömen einer Gasquelle aus Fluor ausgewählt aus der Gruppe bestehend aus SF₆, CF₄, C₂F₆ und NF₃ in die Kammer bei einer Rate im Bereich von 20 bis 200 sccm;
wahlweisem Strömen eines inerten oder nichtreaktionsfähigen Gases in die Kammer; und
Entzünden eines Plasmas in der Kammer bei einem Leistungspegel im Bereich von 50 bis 400 Watt, während die Gasquelle aus Fluor darin fließt, um die Ablagerungen von dem Aufnehmer zu entfernen;
Stoppen der Strömung der Gasquelle aus Fluor in die Kammer;
anschließendem Strömen einer Gasquelle aus Wasserstoff ausgewählt aus der Gruppe bestehend aus H₂, B₂H₆, PH₃ und eines C₁-C₂-Kohlenwasserstoffs in die Kammer bei einer Rate von 100 bis 500 sccm;
wahlweisem Strömen eines inerten oder nichtreaktionsfähigen Gases in die Kammer; und
Aufrechterhalten eines Plasmas in der Kammer bei einem Leistungspegel im Bereich von 50 bis 400 Watt während der Strömung der Gasquelle aus Wasserstoff hierin zur Entfernung von restlichem Fluor von dem Aufnehmer, wobei der Aufnehmer in einem Temperaturbereich von etwa 150°C bis etwa 525°C während des Reinigungsvorgangs gehalten wird.

## Revendications

1. Procédé d'élimination de dépôts de tungstène ou de siliciure de tungstène depuis un suscepteur dans une chambre de dépôt sous vide, où ladite chambre est maintenue dans une gamme de pression comprise entre environ 0,26 et environ 1,333 mbar (environ 0,2 à environ 1 Torr) sans laisser de résidus de fluor dans ladite chambre, ledit procédé comprenant les étapes suivantes :
le chauffage dudit suscepteur et son maintien dans une gamme de température allant de 450° à 475°C lorsque la chambre et le suscepteur sont utilisés pour un dépôt sur toute la surface, et entre 250°C et 400°C lorsque la chambre et le suscepteur sont utilisés pour un dépôt sélectif ;
l'écoulement d'une source gazeuse de fluor choisie dans la classe comprenant SF₆, CF₄, C₂F₆, et NF₃ jusque dans ladite chambre à un débit compris dans la gamme allant de 20 à 200 cm³/min ;
le cas échéant l'écoulement d'un gaz inerte ou non réactif dans ladite chambre ; et
l'allumage d'un plasma dans ladite chambre à un niveau d'énergie compris dans la gamme allant de 50 à 400 watts tandis que ladite source gazeuse de fluor s'y écoule pour éliminer lesdits dépôts dudit suscepteur ;
l'interruption de l'écoulement de ladite source gazeuse de fluor dans ladite chambre ;
puis l'écoulement d'une source gazeuse d'hydrogène choisie dans la classe comprenant H₂, B₂H₆, PH₃ et un hydrocarbure ayant 1 ou 2 atomes de carbone dans ladite chambre à un débit compris dans la gamme allant de 100 à 500 cm³/min ;
le cas échéant l'écoulement d'un gaz inerte ou non réactif dans ladite chambre ; et
le maintien d'un plasma dans ladite chambre à un niveau d'énergie compris dans la gamme allant de 50 à 400 watts pendant l'écoulement de ladite source gazeuse d'hydrogène dans ladite chambre pour éliminer le fluor résiduel dudit suscepteur, ledit suscepteur étant maintenu dans une gamme de température allant d'environ 150°C à environ 525°C pendant ledit procédé de nettoyage.
